# EUROPEAN PATENT APPLICATION

(11) **EP 1 318 424 A2**
(43) Date of publication of application: **11.06.2003**
(21) Application number: 02027281.1
(22) Date of filing: 06.12.2002
(51) Int. Cl.: G02B 7/00, G02B 7/182, G03F 7/20

(54) **Non-contacting holding device for an optical component**

(30) Priority: 06.12.2001 JP 2001372751
(71) Applicant: Nikon Corporation, Tokyo 100 (JP)
(72) Inventor: Miura, Takaharu, c/o Nikon Corpoaration, Tokyo 100 (JP)
(74) Representative: Meddle, Alan Leonard

(57) **Abstract**

A device for holding an optical component relative to a mounting surface in an optical system, the holding device comprising: a mounting member configured for mounting the holding device to the mounting surface; and a receptacle configured to receive and hold a respective portion of the optical component without contacting the optical component.

## Description

### Field

This disclosure pertains to high-precision optical systems as used in, for example, microlithography systems for transfer-exposing a pattern onto an exposure-sensitive substrate. (Microlithography is a key technique used in the fabrication of semiconductor integrated circuits, displays, and the like.) More specifically, the disclosure pertains to devices for holding an optical component (e.g., a lens, a mirror, or a light source) in a high-precision optical system, and to optical systems and microlithography systems including such devices, especially optical systems in which the optical pathway is in a subatmospheric ("vacuum") environment.

### Background

As performance demands imposed on optical systems have become increasingly stringent, the accuracy and precision with which components used in such systems are manufactured have had to be increased correspondingly. This trend has been especially pronounced in optical systems of microlithography systems used for transfer-exposing intricate patterns onto substrates such as semiconductor wafers. In fact, the relentless demand for maximal density and miniaturization of active circuit elements in semiconductor integrated circuits and other microelectronic devices requires that most microlithography systems (and their constituent optical systems) operate at or near their theoretical resolution limits. These demands in the evolution of microelectronic devices also have fueled the development of "next generation" lithography (NGL) technology (utilizing, for example, charged particle beams, X-ray beams, or "extreme ultraviolet" beams) offering prospects of significantly higher resolution than obtainable with conventional lithography tools that use visible or ultraviolet light.

However, each of these NGL technologies poses distinctive technical challenges. For example, the optical systems used in extreme ultraviolet lithography (EUVL; performed at wavelengths ranging from 11 to 13 nm) must utilize EUV-reflective multilayer-film mirrors rather than lenses because no known materials are sufficiently refractive to EUV light of such wavelengths. To achieve adequate reflectivity and sufficiently low aberrations from the mirrors, the reflective surfaces of the mirrors must be formed and coated extremely accurately, and the mirrors must be mounted and positioned relative to each other with extremely high accuracy and stability. Also, because EUV light is attenuated by propagation through air, EUV optical systems must be contained in subatmospheric-pressure ("vacuum") chambers.

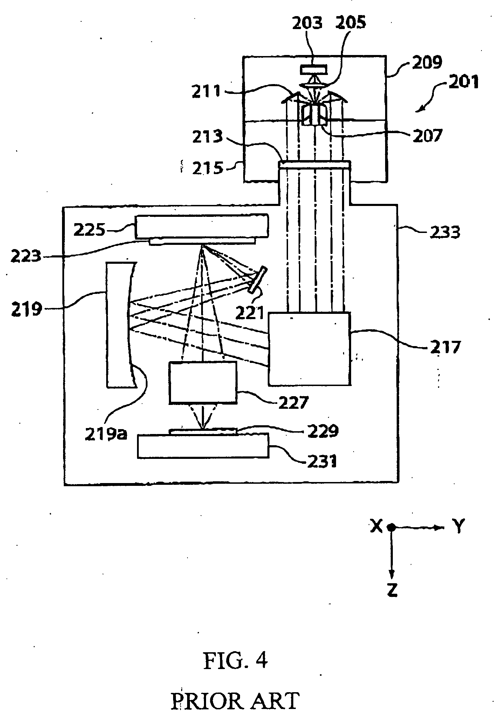

Basic concepts of EUVL are shown in FIG. 4. The system 201 of FIG. 4 performs projection-exposure of a pattern in a step-and-scan manner using EUV light having wavelength in the range of 11 to 13 nm. At the most upstream end of the system 201 is a laser light source 203 that generates laser light having a wavelength ranging from infrared to visible. For example, the laser light source 203 can be a YAG laser or excimer laser. Laser light from the laser light source 203 is converged by a condenser-lens system 205 onto a downstream a laser-plasma light source 207.

The laser-plasma light source 207 produces EUV light having a wavelength of approximately 13 nm. To such end, and as well-known in the art, the laser-plasma light source 207 is supplied, at the convergence point of the laser light from the light source 207, with xenon gas from a discharge nozzle (not shown). As the xenon gas discharged from the nozzle is illuminated by the laser light, the gas is heated instantaneously to a temperature sufficiently high to produce a plasma from the highly energized molecules of the gas. As the energized gas molecules undergo a spontaneous transition to a lower-potential state, they emit EUV radiation. As noted above, EUV light does not pass readily through air at atmospheric pressure. Consequently, the laser-plasma light source 207 and the trajectory path of EUV light from the laser-plasma light source (and desirably also the laser light source 203) are enclosed in a vacuum chamber 209 evacuated to a suitable vacuum level.

Disposed immediately upstream of the laser-plasma light source 207 is a collimating mirror 211 having an EUV-reflective surface profiled as a paraboloid of revolution. The collimating mirror 211 includes a surficial Mo/Si multilayer film that renders the surface of the collimating mirror 211 highly reflective to incident EUV radiation. Hence, as EUV light produced by the laser-plasma light source 207 is incident upon the collimating mirror 211, only EUV light having a wavelength near 13 nm is reflected "downward" (in the figure) as a collimated beam of EUV light. Situated downstream of the collimating mirror 211 is a filter 213 made, e.g., of beryllium and having a thickness of 0.15 nm, for example. The filter 213 blocks transmission of visible light while allowing passage only of the desired wavelength of EUV light. Thus, of the EUV light reflected by the collimating mirror 211, only the desired EUV wavelength passes through the filter 213. The filter 213 and its immediate vicinity are enclosed by a chamber 215, which typically is contiguous with the vacuum chamber 209.

An exposure chamber 233 is situated downstream of the filter 213 and connected to the chamber 215. Inside the exposure chamber 233 is an illumination-optical system 217 that comprises multiple multilayer-film condensing mirrors as well as a fly-eye mirror (not detailed). The beam of EUV light from the filter 213 is trimmed so as to have an arc-shaped transverse profile and directed toward the left in the figure.

A multilayer-film mirror 219, reflective to incident EUV light, is disposed so as to reflect, in a convergent manner, the arc-shaped beam from the illumination-optical system 217. The mirror 219 is disk-shaped and has a concave reflective surface 219a. EUV light reflected from the mirror 219 is reflected by a planar bending mirror 221 disposed at an angle relative to the mirror 219. Thus, EUV light reflected from the mirrors 219, 221 is incident convergently on a reflective reticle 223 horizontally disposed "above" the mirror 221, with the reflective surface of the reticle 223 facing "downward" in the figure.

Each of the mirrors 219, 221 is made from a respective plate of quartz or other low-thermal-expansion material. The reflective surface of each mirror is worked extremely accurately and coated with a multilayer film configured to render the reflective surface highly reflective to incident EUV light of a desired wavelength and to minimize aberrations. For example, so as to be highly reflective to an EUV wavelength of 13 nm, the multilayer film comprises alternating superposed thin layers of Mo (molybdenum) and Si (silicon). For other EUV wavelengths in the range of 10-15 nm, the multilayer film can comprise individual layers of other substances such as Ru (ruthenium), Rh (rhodium), Be (beryllium), B₄C (carbon tetraborate), *etc.*

Since the reticle 223 is a reflective reticle, it also has an EUV-reflective multilayer film on its surface. A desired reticle pattern to be transfer-exposed from the reticle 223 to a downstream substrate 229 is formed on the multilayer reflective film of the reticle 223. The "upper" surface of the reticle 223 is mounted to a reticle stage 225 that is movable in at least one of the X and Y directions to allow EUV light reflected by the bending mirror 221 to irradiate selected regions of the reticle 223 in a sequential scanning manner.

Downstream of the reticle 223 are a projection-optical system 227 and the substrate 229 (*e*.*g*., a semiconductor wafer coated with a suitable "resist" that is sensitive to exposure by EUV light. The projection-optical system 227 comprises multiple EUV-reflective multilayer-film mirrors that collectively project (with demagnification) a focused image of the illuminated region of the reticle 223 onto a corresponding region on the "sensitive" surface of the substrate 229. The demagnification is according to a "demagnification ratio" such as 1/4, for example. The substrate 229 is mounted to a substrate stage 231 using a suitable electrostatic chuck or the like. The substrate stage 231 usually is movable in all of the X, Y, and Z directions.

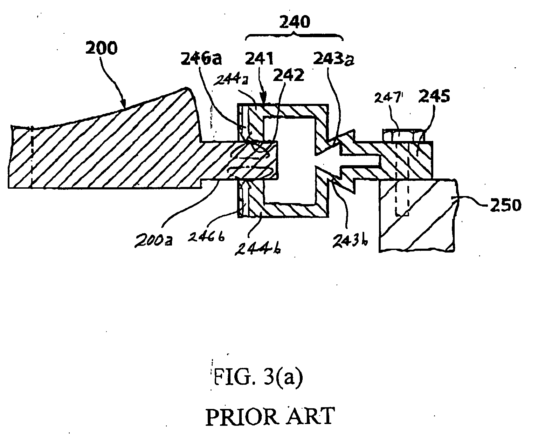

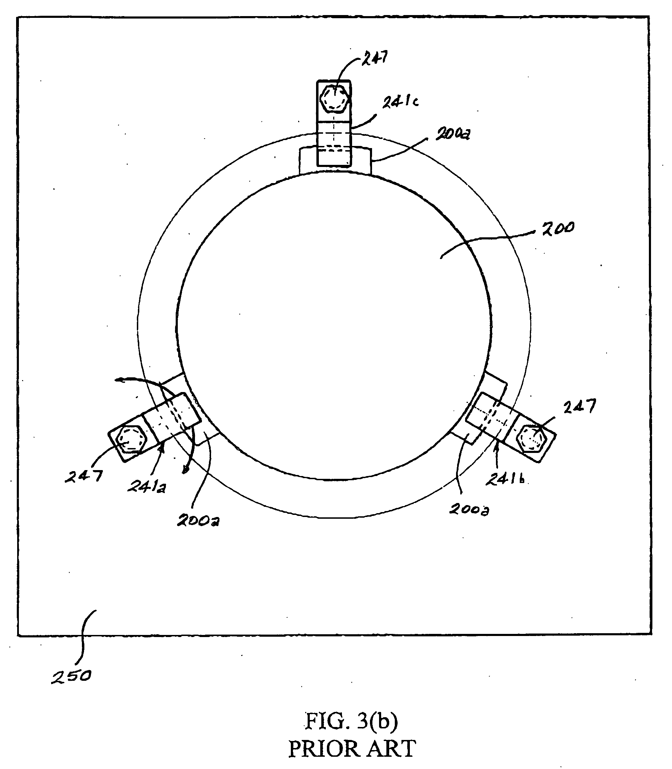

A conventional holding device 240 for holding an optical component 200 in a system (*e*.*g*.*,* the system of FIG. 4) is depicted in FIGS. 3(a)-3(b). The holding device 240 is used, for example, for holding a multilayer-film EUV-reflective mirror in the illumination-optical system 217 or projection-optical system 227, relative to the exposure chamber 233. The holding device 240 comprises a "kinematic clamp" 241 of a type conventionally used for holding a precision optical component such as a mirror or laser. The clamp 241 in FIG. 3 is called a "three-point" clamp because the clamp has three portions 241a, 241b, 241c situated at respective locations around the optical component 200 (FIG. 3(b)). The clamp 241 in FIG. 3 is a "kinematic three-point clamp" that holds the optical component 200 at three equally spaced places around the periphery of the optical component 200. The clamp 241 is configured to hold a mounting ear 200a extending from the periphery of the optical component 200. The mounting ear 200a can extend around the periphery of the optical component 200 or be provided at respective locations on the periphery at which the optical component 200 is to be clamped by a respective portion 241a, 241b, 241c of the three-point clamp 241.

At each clamping location the respective portion of the clamp 241 comprises opposing jaws 244a, 244b that define a receptacle 242 therebetween into which the respective mounting ear 200a (or portion thereof) is inserted. The jaws 244a, 244b are attached to a clamp-mounting member 245 via respective flexure springs 243a, 243b. The clamp-mounting member 245 is affixed to a suitable rigid base 250, usually by a fastener 247 that defines a respective pivot axis of the clamp portion and about which the respective clamp portion can pivot for clamping or unclamping the optical component 200 (see arc-shaped arrows in FIG. 3(b)).

The holding device 240 of FIG. 3 exhibits the following problems, especially when used in an EUVL system:
(1) The kinematic clamp portions 241a, 241b, 241c can cause deformation of the reflective surface of the optical component 200 due to stresses imposed at respective points of contact of the opposing jaws 244a, 244b with the mounting ears 200a. *I*.*e*., although the clamp is kinematic, the stresses imposed at the three points of contact can deform the optical component 200. In FIG. 3 the respective distribution of stress produced by each pair of jaws 244a, 244b in the respective mounting ear 200a is indicated by a respective dot-and-dash line "loop." The respective forces applied by the jaws 244a, 244b to the mounting ear 200a are denoted by respective solid-line arrows 246a, 246b.
(2) No means (*e*.*g*., mirror-cooling means) is provided for suppressing temperature increases of the mirror 200 that can cause deformation of the mirror 200.
(3) Stress in and/or strain (*e*.*g*., deformation) of the base 250 can be transmitted to the mirror 200 easily *via* the holding device 240.
(4) If the holding device 240 is being used for holding a transparent lens, substantial stress can be created in the lens by tightening the clamp 241. This stress can cause, for example, birefringence in the lens, which can degrade the imaging performance of the lens.

### Summary

In view of the shortcomings of conventional optical-component-holding devices as summarized above, the present invention provides, *inter alia,* optical-component-holding devices that can be used in a vacuum environment, that provide holding-restraint of the optical component using a uniformly applied clamping force, and that provide improved suppression of temperature rises of the optical component.

To such ends, and according to one aspect of the invention, devices are provided for holding an optical component relative to a mounting surface in an optical system. An embodiment of such a device comprises a mounting member configured for mounting the holding device to the mounting surface, and a receptacle configured to receive and hold a respective portion of the optical component without contacting the optical component. For example, if the optical component includes a mounting flange, then the receptacle is configured to receive and hold a respective portion of the mounting flange. The receptacle comprises at least one fluid bearing situated and configured, whenever a fluid (*e*.*g*., gas such as air) is being supplied to the fluid bearing, to support the optical component without contacting the optical component. Desirably, the receptacle defines at least one exhaust groove situated and configured, whenever fluid is being supplied to the fluid bearing, to scavenge the fluid discharged from the fluid bearing and to exhaust the scavenged fluid.

In a more specific configuration, for an optical component that includes a mounting flange, the receptacle of the holding device comprises first and second facing walls defining a channel therebetween, the channel being configured to receive a respective portion of the mounting flange. The channel has respective sides defined by the first and second facing walls, and a bottom, and the holding device further comprises a respective gas bearing situated in each of the sides and bottom of the channel. Each gas bearing comprises an air pad through which air is discharged, from an air supply, toward a respective region of the mounting flange. Each gas bearing further can comprise a respective exhaust groove extending around the air pad, wherein the exhaust groove serves to scavenge and exhaust air discharged from the respective air pad. Multiple exhaust grooves can be provided for each air pad, wherein the exhaust grooves collectively provide "differential exhaust" (*e*.*g*., to atmospheric pressure, to a relatively low vacuum, and to a relatively high vacuum) for each air pad.

Desirably, the receptacle comprises a position/attitude-adjustment mechanism situated and configured to adjust at least one of position and attitude of the optical component relative to the mounting member without contacting the optical component. A respective position-attitude adjustment mechanism can be associated with each fluid bearing. Each position/attitude-adjustment mechanism can comprise a non-contacting position sensor and a non-contacting positional actuator.

The optical component can include a cooling passage for conducting a fluid through the optical component for cooling the optical component. In such a situation the receptacle of the holding device desirably is configured to deliver fluid to the cooling passage whenever the optical component is being held by the holding device. Thus, the fluid is allowed to flow from the receptacle through the cooling passage so as to cool the optical component. In this configuration gas discharged from the gas bearing can serve as a cooling fluid by being scavenged by the conduit and routed through the cooling passage as the optical component is being held by the holding device.

An embodiment of the holding device includes a mounting means for mounting the device to the mounting surface. The embodiment also includes a non-contacting receptacle means for receiving and holding a respective portion of the optical component without contacting the optical component. The non-contacting receptacle means desirably comprises fluid-bearing means for discharging a stream of fluid (*e*.*g*., gas such as air) at a respective portion of the optical component, wherein the discharged fluid serves to support the optical component without contacting the optical component. Exhaust means can be provided for scavenging and exhausting fluid discharged from the fluid-bearing means. Position/attitude-adjustment means can be provided for adjusting at least one of position and attitude of the optical component relative to the mounting means without contacting the optical component. Optical-component cooling means can be provided for cooling the optical component being held by the holding device. Scavenging means can be provided for scavenging fluid discharged from the fluid-bearing means. The scavenged fluid can be routed to the optical-component cooling means and used for cooling the optical component.

According to another aspect of the invention, optical systems are provided. An embodiment of such a system comprises at least one optical component and a device for holding the optical component and for mounting the optical component to a mounting surface in the optical system. The holding device desirably is as summarized above. By way of example, the optical component is an EUV-reflective mirror.

If the optical component includes a cooling passage, the receptacle can define a conduit situated to open into the cooling passage whenever the optical component is mounted to the holding device. Thus, cooling fluid can be made to flow from the conduit through the cooling passage and thereby cool the optical component.

According to another aspect of the invention, lithographic exposure systems are provided. An embodiment of such a system comprises a chamber in which lithographic exposure is performed on a substrate by an energy beam, and an optical system situated within the chamber and configured to direct the energy beam for making the lithographic exposure. The optical system comprises at least one optical component and a device for holding the optical component and for mounting the optical component to a mounting surface in the optical system. The holding device desirably is as summarized above.

The optical system can be a projection-optical system situated and configured to direct the energy beam to the substrate.

If the chamber is a vacuum chamber, then the mounting flange or receptacle desirably defines at least one exhaust groove situated and configured, whenever gas is being supplied to the gas bearing of the holding device, to scavenge the gas discharged from the gas bearing and to exhaust the scavenged gas.

If the optical component defines an internal cooling passage for conducting a cooling fluid used for cooling the optical component, then a conduit can be situated to deliver the cooling fluid to the cooling passage.

According to yet another aspect of the invention, methods are provided, in the context of an optical system comprising a mounting surface and an optical component that includes a mounting portion, mounting the optical component in the optical system. An embodiment of such a method comprises mounting the optical component to a holding device that defines a receptacle configured to receive the mounting portion and to hold the optical component *via* the mounting portion without contacting the mounting portion. The method also includes the step of affixing the holding device to the mounting surface of the optical system.

The method further can comprises the step of cooling the optical component as the optical component is being held by the holding device.

The mounting step further can include the step of providing a non-contacting gas bearing between the mounting portion and the receptacle. In this situation the step of providing a gas bearing comprises discharging air from a gas pad situated in the receptacle (the air being discharged so as to form the gas bearing) and scavenging the discharged air from the gas bearing and discharging the air.

The method further can comprise the step of adjusting at least one of position and attitude of the optical component relative to the mounting surface, without contacting the optical component.

With a holding device as disclosed herein, localized holding force is not applied to the optical component by the holding device. Consequently, local deformation, non-symmetrical deformation, and/or stress birefringence of the optical component are avoided.

Since the holding devices are usable in a vacuum environment, holding devices that include a position/attitude-adjustment mechanism are especially advantageous because such a mechanism allows for remote adjustments of position and attitude of the optical component, including in real time. An exemplary attitude/position-adjustment mechanism includes a positional sensor (*e.g*., electrostatic-capacity sensor or the like) and a non-contacting-type actuator (*e*.*g.,* linear motor or the like).

The gas bearing avoids contact between the holding device and the optical component. Hence, the gas bearing absorbs any deformation that otherwise would be transmitted to the optical component from the mounting surface to which the holding device is attached. Also, since the discharged gas desirably is scavenged, a vacuum environment for the optical system can be maintained easily. Also, the holding device allows integration of the gas bearing with optical-component cooling, thereby suppressing thermal deformation accompanying a temperature rise of the optical component.

The foregoing and additional advantages of the invention will be more readily apparent from the following detailed description, which proceeds with reference to the accompanying drawings.

### Brief Description of the Drawings

FIG. 1(a) is an elevational section of an optical-component-holding device according to a first representative embodiment.
FIG. 1 (b) is a top plan view showing three holding devices of the first representative embodiment positioned around the periphery of a mirror as a representative optical component. The mirror includes "air passages" ("cooling passages") that route a cooling fluid (*e*.*g*., air) through the mirror independently of fluid delivered to the holding devices.
FIG. 1(c) is a top plan view showing three holding devices of the first representative embodiment positioned around the periphery of a mirror as an exemplary optical component. The mirror includes "air passages" ("cooling passages") that route a cooling fluid (*e*.*g*., air) from the holding devices through the mirror.
FIG. 1(d) is an elevational section of the optical-component-holding device of the first representative embodiment, detailing an exemplary path of fluid (*e*.*g*., air) from the air pads to the air passages in the mirror.
FIG. 1(e) is an elevational section of the optical-component-holding device of the first representative embodiment, detailing three exhaust grooves situated around an air pad.
FIG. 1(f) is a view, along the line 1(f)-1(f) of FIG. 1(e), showing the configuration of the exhaust grooves.
FIG. 1(g) is an example configuration of a device used for radially moving and positioning three optical-component-holding devices of the first representative embodiment relative to an optical component. The depicted device is configured in the manner of a chuck such as used on a machine lathe.
FIG. 1(h) is an elevational section of an alternative configuration of the first representative embodiment, in which exhaust grooves are defined in the mounting flange of the mirror or other optical component held by the optical-component-holding device.
FIG. 2(a) is an elevational section showing certain details (namely the air pads, exhaust grooves, and actuators) of an optical-component-holding device according to a second representative embodiment.
FIG. 2(b) is an elevational section showing certain other details (namely of exemplary actuators and proximity sensors) of the second representative embodiment.
FIG. 3(a) is an elevational section of a conventional optical-component-holding device that includes a kinematic three-point clamp.
FIG. 3(b) is a plan view of the device of FIG. 3(a).
FIG. 4 is a schematic optical diagram of certain components and systems of a conventional extreme ultraviolet lithography (EUVL) system.

### Detailed Description

The invention is described below in the context of representative embodiments that are not intended to be limiting in any way.

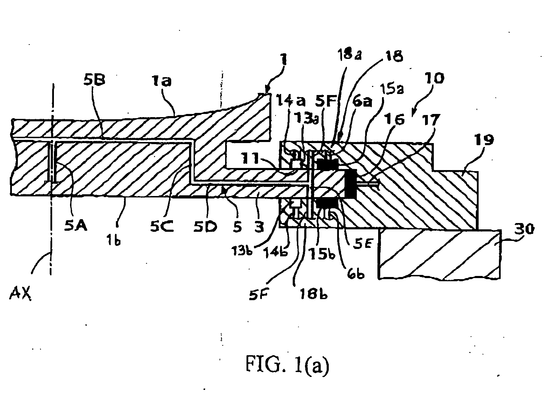

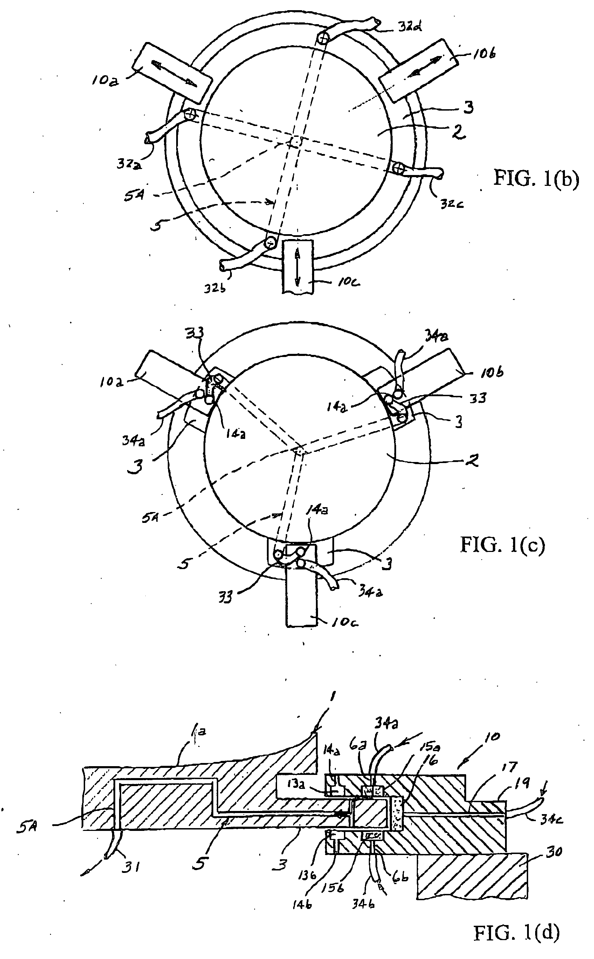

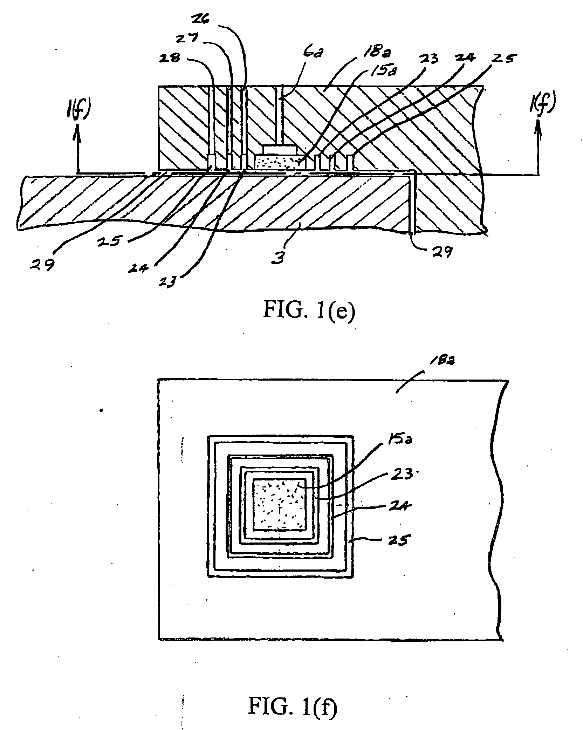

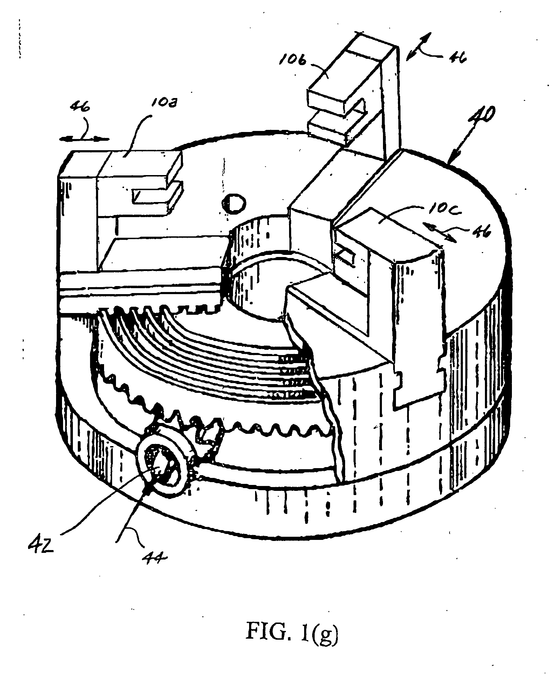

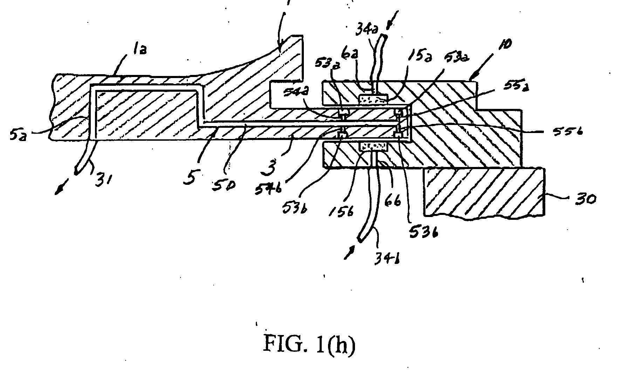

A first representative embodiment of an optical-component-holding device 10 is shown in FIG. 1(a). The device 10 of FIG. 1(a) is depicted holding a mirror 1 as an exemplary optical component. The device 10 includes a mounting member 19 that is mounted to a suitable mounting surface 30 of the optical system. The device also includes a receptacle 18 configured to receive a respective portion of a mounting flange 3 (as an exemplary "mounting portion") of the mirror 1.

The mirror 1 can be configured for use as an EUV-reflective multilayer-film mirror for use in a projection-optical system of an EUVL system. As such, the mirror 1 typically is disk-shaped, with a concave reflective surface 1a. Extending around the periphery of the mirror 1 and outward from the periphery is the mounting flange 3 used for mounting the mirror 1 to the holding device 10. The mounting flange 3 can extend completely around the mirror 1 or extend locally from the mirror in the manner of mounting "ears" each configured as a separate extension from a respective location on the edge of the mirror 1.

The mirror 1 desirably defines an interior passage 5 that, in the embodiment of FIG. 1(a), comprises constituent "air passages" ("cooling passages") 5A-5E. The passage 5 is used for conducting a flow of air or other fluid suitable for cooling the mirror 1. In this embodiment the air passage 5A extends axially at the center of the mirror 1, from the rear surface 1b toward the reflective surface 1a. (See also FIGS. 1(b)-1(d).) Further regarding the embodiment of FIG. 1(a), the air passage 5B connects at a right angle to the air passage 5A and extends "horizontally" (in the figure) in a radial manner below the reflective surface 1a. The air passage 5C connects at a right angle to the air passage 5B and extends parallel to the axis AX from the air passage 5B toward the rear surface 1b of the mirror. The air passage 5D connects at a right angle to the air passage 5C and extends "horizontally" (in the figure) in a radial manner toward the mounting flange 3. The air passage 5E extends "vertically" (in the figure) from the air passage 5D parallel to the axis AX.

The passages 5 desirably extend with radial symmetry relative to the center of the mirror 1 (*i*.*e*., the axis AX). For example, in FIGS. 1(b) and 1(c), three or four, respectively, passages 5 are shown extending radially outward from the axis. The passages 5 can be formed by bonding together two mirror members (*i*.*e.,* a "front" member and a "rear" member) having mating surfaces in which corresponding grooves have been cut. The distal end of the air passage 5A is connected to a flexible conduit 31 (made, *e.g.*, of flexible polymer) for conducting fluid to or from the passages 5.

The passages 5 can be supplied with air or other fluid in any of various ways. For example, in FIG. 1(b), each air passage 5 opens onto the mounting flange 3 and is connected to a respective flexible conduit 32a-32d. The conduits 32a-32d in FIG. 1(b) can be either fluid-supply conduits (with the conduit 31 being an exhaust conduit), or fluid-exhaust conduits, and are used solely for delivering or exhausting air (or other fluid) from the passages 5. In the embodiment of FIG. 1(c), each passage 5 opens onto a respective mounting-flange portion 3. To supply fluid to the passages 5 in the configuration shown in FIG. 1(c), respective flexible conduits 33 connect the passages 5 to respective conduits 14a that connect to respective exhaust grooves (see below). Thus, air (or other fluid) discharged from the air pads is routed to the passages 5 and used as a cooling fluid for the mirror 1.

In the embodiment of FIG. 1(a) the distal ends of the air passage 5E are aligned with corresponding air passages 5F defined in facing walls 19a, 19b of the mounting member 19, described later below. Fluid (*e.g.*, air) supplied to the air passage 5F flows from the air passage 5F into and through the air passages 5E, 5D, 5C, 5B, 5A so as to conduct heat away from the mirror 1. Thus, thermal deformation of the mirror 1 that otherwise would accompany a temperature increase of the mirror is decreased.

The air passages 5A-5E of the mirror 1 also can be used for conducting away fluid (*e*.*g*., air) discharged from air pads 15a, 15b, 16, as noted above and described later below. Thus, at least some of the fluid supplied to the air pads 15a, 15b, 16 also may be used for cooling the mirror 1. Alternatively, fluid may be supplied to the air pads 15a, 15b, 16 from the air passages 5F.

As shown in FIGS. 1(b) and 1(c), at least three (desirably three) devices 10a, 10b, 10c are disposed at respective locations around the periphery of the mirror 1. Desirably, the devices 10a-10c are disposed equi-angularly relative to each other. The devices 10a-10c desirably are movable (as indicative of exemplary movability, see radial arrows in FIG. 1 (b)) relative to the mirror 1 by means of respective movement mechanisms (not shown). An exemplary movement mechanism is shown in FIG. 1(g), in which the devices 10a-10c are mounted on a chuck mechanism 40 similar to that used for holding a workpiece on a machine lathe. A suitable tool is inserted (arrow 44) into an adjustment receptacle 42 and used for rotating the receptacle 42. Rotating the receptacle 42 causes simultaneous radial movement (arrows 46) of the devices 10a-10c relative to each other. By moving the devices 10a-10c in this manner, attachment and removal of the mirror 1 can be performed easily.

Returning to FIG. 1(a), the receptacle 18 includes respective facing walls 18a, 18b that define a channel 11 therebetween for receiving the respective portion of the mounting flange 3. The channel 11 includes an air pad 15a, 15b in each of the facing walls 18a, 18b, respectively, and desirably also an air pad 16 in the "bottom" (left-facing edge in the figure) of the channel 11. The air pads 15a, 15b, 16, charged with air or other suitable fluid *via* respective conduits 34a, 34b, 34c (see FIG. 1(d)), allow the mounting flange 3 to be held by the receptacle 18 (*i.e*., held in the channel 11) without actually contacting the facing walls 18a, 18b or any other part of the receptacle 18. Thus, the holding device 10 of this embodiment is a "non-contacting" type holding device that holds the mirror by fluid flotation.

Each facing wall 18a, 18b in the configuration of FIG. 1(a) defines at least one respective exhaust groove 13a, 13b. Although only one pair of opposing exhaust grooves 13a, 13b is shown in FIG. 1(a), multiple exhaust grooves desirably are provided in each facing wall 18a, 18b, wherein the grooves collectively perform "differential" exhaust. For example, as shown in FIGS. 1(e)-1(f) and with respect to a facing wall 18, one exhaust groove 23 is connected to an atmospheric-pressure-release conduit 26 (such as the conduits 14a, 14b shown connected to the grooves 13a, 13b, respectively) providing exhaust to atmosphere. Another exhaust groove 24 is connected to a low-vacuum-exhaust conduit 27 providing exhaust to a relatively low vacuum, and yet another exhaust groove 25 is connected to a high-vacuum-exhaust conduit 28 providing exhaust to a relatively high vacuum. Desirably, a set of exhaust grooves (one atmospheric 23, one low-vacuum 24, one high-vacuum 25) is provided for each air pad 15a, 15b, 16. As shown in FIG. 1(f), each set of exhaust grooves 23, 24, 25 desirably extends around the circumference of the respective air pad.

In the embodiment of FIG. 1(a), the air pads 15a, 15b, 16 are located "deeper" (further to the right) in the channel 11 than the exhaust grooves 13a, 13b. Whenever the mirror 1 is mounted in the holding device 10, the air pads 15a, 15b are situated opposite respective faces of the mounting flange 3, and the air pad 16 is situated opposite the distal edge of the mounting flange 3.

Each of the air pads 15a, 15b, 16 comprises a respective porous member through which gas (as an exemplary fluid, supplied *via* the conduits 6a, 6b, 17, respectively) is discharged toward the respective opposing surface of the mounting flange 3. Whenever the mounting flange 3 is seated fully in the channel 11 as shown in FIG. 1(a), and gas is being discharged from the respective air pads, the respective gap between each air pad and the respective opposing surface of the mounting flange 3 is approximately 5 µm (see gap 29 in FIG. 1(e), for example). Thus, the air pads 15a, 15b, 16 (and any associated exhaust grooves) collectively comprise a fluid-flotation bearing for the mirror 1. This fluid-flotation bearing can be used in a vacuum environment such as the subatmospheric pressure inside the chamber 233 shown in FIG. 4.

By optimally specifying the static rigidity of the air pads 15a, 15b, 16, the resonant frequency of the mirror 1 can be made sufficiently high, and air-pad vibration can be minimized sufficiently to avoid interfering with proper functioning of the mirror. Multiple sets of air pads 15a, 15b, 16 (each set desirably being in a respective device 10a-10c) are situated desirably equi-angularly around the circumference of the mirror 1.

In the embodiment of FIG. 1(a) air (as an exemplary fluid) is supplied to the air pads 15a, 15b, 16 from passages 6a, 6b, 17 inside the mounting member 19 and *via* supply conduits 34a, 34b, 34c. Air discharged from the air pads 15a, 15b, 16 is directed to the opposing surface of the mounting flange 3 of the mirror 1. Nearly all this discharged air is scavenged by the exhaust grooves 13a, 13b through respective conduits 14a, 14b. Air discharged from the air pads 15a, 15b, 16 also can be routed through the air passages 5A-5E inside the mirror 1 (see FIG. 1(d)).

Alternatively to defining exhaust grooves in the facing walls, exhaust grooves can be defined in the mounting flange 3 of the mirror 1. For example, as shown in FIG. 1(h), exhaust grooves 53a are associated with the air pad 15a, and exhaust grooves 53b are associated with the air pad 15b. The exhaust grooves 53a, 53b are connected to the air passage 5 *via* conduits 54a, 54b, respectively, defined in the mounting flange 3. Thus, air discharged from the air pads 15a, 15b is scavenged by the exhaust grooves 53a, 53b and used directly for cooling the mirror 1.

As discussed above, multiple exhaust grooves 13a, 13b can be provided so as to optimize the number of differential exhaust levels according to the prevailing vacuum level. For example, a sufficient number of exhaust grooves can be provided to provide two-level or three-level differential exhaust (*e.g.*, respective grooves providing exhaust to atmosphere, exhaust to low vacuum, and exhaust to high vacuum). See FIGS. 1(e) and 1(f), discussed above, for an example of three exhaust grooves. Further by way of example, whenever the mirror I must be enclosed in a high-vacuum environment during use, at least one exhaust groove in each facing wall 19a, 19b provides high-vacuum exhaust. In the depicted embodiments each high-vacuum exhaust groove is located in the respective facing wall 18a, 18b closest, of all the exhaust grooves, to the high-vacuum environment of the mirror, which provides the best avoidance of substantial leaks of air into the high-vacuum environment. Otherwise, such leaks could deteriorate the high-vacuum condition substantially. The same principle desirably is applied whenever the exhaust grooves are located in the mounting flange 3 (FIG. 1(h)).

The embodiment of FIG. 1(a) and other embodiments discussed above effectively prevent deformation of the mounting member 19 and receptacle 18 by stress imparted thereto from the mounting surface 30, and prevents mounting stress from being transmitted to the mirror 1. This stress isolation is provided by the non-contacting fluid bearings established by the air pads 15a, 15b, 16 and exhaust grooves (*e*.*g*.*,* grooves 13a, 13b) of the receptacle 18. Thus, localized holding force is not applied to the mirror 1, which prevents local deformation and non-symmetrical deformation of the mirror 1, thereby ensuring the accuracy and precision of mirror performance.

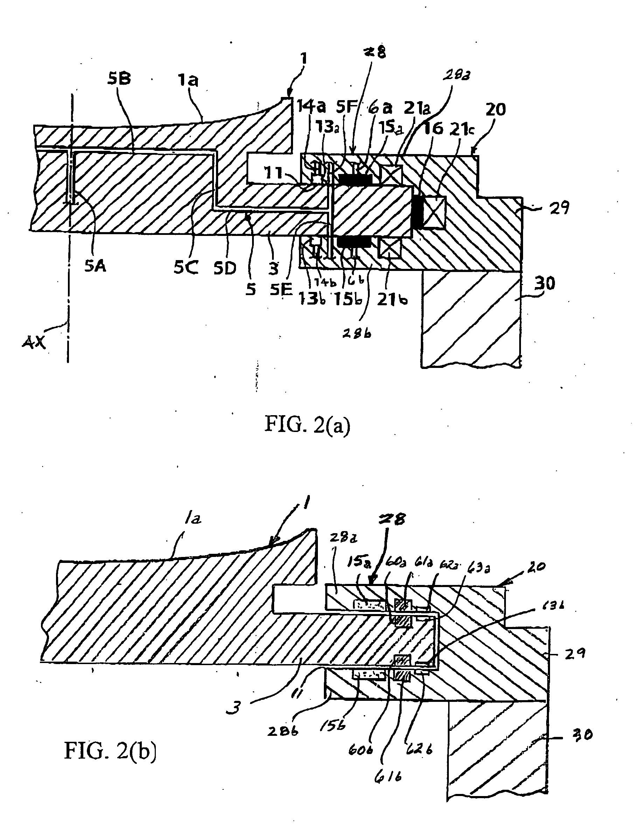

A second representative embodiment of an optical-component-holding device 20 is shown in FIGS. 2(a)-2(b). The device 20 is depicted holding a mirror 1 as an exemplary optical component. The device 20 includes a receptacle 28 and a mounting member 29, the latter being mounted to a suitable mounting surface 30 of the optical system.

The device 20 of FIG. 2(a) is similar to the device 10 of FIG. 1, but additionally comprises one or more position/attitude-adjustment mechanisms 21a, 21b, 21c situated in the receptacle 28. Each position/attitude-adjustment mechanism 21a, 21b, 21c desirably comprises a respective non-contacting position sensor and a respective non-contacting actuator. The position/attitude-adjustment mechanisms 21a, 21b, 21c desirably are situated inboard of the air pads 15a, 15b, 16. Without intending to be limiting, an exemplary non-contacting position sensor is an electrostatic-capacitance sensor (see below), and an exemplary non-contacting actuator is a linear motor. The position sensors and actuators are connected to and driven by respective drivers (not shown), and achieve active adjustment of the mirror 1 to the correct position and attitude in real time.

Similar to the embodiment of FIG. 1(a), the receptacle 28 of the embodiment of FIGS. 2(a)-2(b) includes facing walls 28a, 28b that include the air passages 5F, the air pads 15a, 15b, 16, conduits 14a, 14b, and exhaust grooves 13a, 13b. The receptacle 28 defines a channel 11, situated between the facing walls 28a, 28b, that receives a respective portion of a mounting flange 3 (as a representative "mounting portion") of the mirror 1.

A specific example is shown in FIG. 2(b), in which certain detail shown in FIG. 2(a) is omitted for clarity. Shown in FIG. 2(b) are the facing walls 28a, 28b of the receptacle 28 that defines the channel 11. The channel 11 receives a respective portion of the mounting flange 3 of the mirror 1. The actuators in this configuration comprise respective permanent magnets 60a, 60b embedded in respective surfaces of the mounting flange 3. Opposing each permanent magnet 60a, 60b is a respective electromagnet 61a, 61b embedded in a respective facing wall 28a, 28b. Appropriate energization of the electromagnets 61a, 61b causes attraction or repulsion relative to the respective permanent magnet 60a, 60b. By controlling the electrical current delivered to each electromagnet 61a, 61b, the respective force between the receptacle 11 and mounting flange 3 can be adjusted. Desirably, the applied forces are in response to positional data provided by the electrostatic capacitance sensors 62a, 63a and 62b, 63b. As shown, for each sensor, one electrode 62a, 62b is embedded in the respective facing wall 28a, 28b, and the other electrode 63a, 63b is embedded in the respective opposing surface of the mounting flange 3. These sensors serve as proximity sensors that are connected to a controller (not shown), wherein the controller processes the proximity data to produce data regarding the gap between the mounting flange 3 and the walls 28a, 28b. The controller desirably also is configured to route appropriate commands as required to the actuators (magnets 62, 63) and, if necessary, to a fluid supply providing fluid to the air pads 15a, 15b.

An optical-component-holding device according to any of the various embodiments described above can be used for holding an optical component (laser, mirror, filter, *etc.)* of an EUVL system such as the system shown in FIG. 4. Thus, the optical component is held with high accuracy and precision, thereby facilitating the obtaining of high-accuracy lithographic transfers performed using the system. The optical-component-holding devices are especially effective in holding optical components in a vacuum environment without deforming the optical components and while allowing small positional adjustments of the optical components to be made. The optical-component-holding devices are not limited to use in EUVL optical systems; the devices also can be employed in any of various other ultra-high-precision optical systems. The optical-component-holding devices also are effective in suppressing the occurrence of local deformation, non-symmetrical deformation, and stress-related birefringence in optical components held by the devices. Achievement of these ends is facilitated by the air pads that define respective non-contacting fluid bearings between the holding device and the optical component. Also, if the optical component includes an internal conduit for circulating a cooling fluid, then the optical component can be cooled (while being held by the holding device) by the circulation of fluid through the conduits, thereby suppressing thermal deformation of the optical component. The fluid used for cooling can be the same fluid as used in the non-contacting fluid bearings.

Whereas the invention has been described in connection with multiple representative embodiments, the invention is not limited to those embodiments. On the contrary, the invention is intended to encompass all modifications, alternatives, and equivalents as may be included within the spirit and scope of the invention, as defined by the appended claims.

The features disclosed in the foregoing description, in the claims and/or in the accompanying drawings may, both separately and in any combination thereof, be material for realising the invention in diverse forms thereof.

## Claims

1. A device for holding an optical component relative to a mounting surface in an optical system, the holding device comprising:
a mounting member configured for mounting the holding device to the mounting surface; and
a receptacle configured to receive and hold a respective portion of the optical component without contacting the optical component.

2. A device according to Claim 1, wherein:
the optical component includes a mounting flange; and
the receptacle is configured to receive and hold a respective portion of the mounting flange.

3. A device according to Claim 1 or 2, wherein the receptacle comprises at least one fluid bearing situated and configured, whenever a fluid is being supplied to the fluid bearing, to support the optical component without contacting the optical component.

4. A device according to Claim 3, wherein the fluid is a gas.

5. A device according to Claim 4, wherein the gas is air.

6. A device according to any one of Claims 3 to 5, further comprising exhaust means for scavenging and exhausting fluid discharged from the fluid-bearing means.

7. A device according to Claim 6, wherein the exhaust means comprises differential exhaust means.

8. A device according to Claim 6 or 7, wherein the receptacle defines at least one exhaust groove situated and configured, whenever fluid is being supplied to the fluid bearing, to scavenge the fluid discharged from the fluid bearing and to exhaust the scavenged fluid.

9. An optical system according to Claim 8, wherein the exhaust groove is defined in the receptacle.

10. A device according to any one of Claims 3 to 9, further comprising a respective position-attitude adjustment mechanism associated with each fluid bearing.

11. A device according to Claim 10, wherein the position/attitude-adjustment mechanism comprises a non-contacting position sensor and a non-contacting positional actuator.

12. A device according to any preceding claim, wherein:
the optical component includes a mounting flange;
the receptacle comprises first and second facing walls defining a channel therebetween, the channel being configured to receive a respective portion of the mounting flange; and
the channel has respective sides defined by the first and second facing walls, and a bottom.

13. A device according to Claim 12, further comprising a respective gas bearing situated in each of the sides and bottom of the channel.

14. A device according to Claim 13, further comprising at least one exhaust groove situated and configured, whenever gas is being supplied to the gas bearings, to scavenge the gas discharged from the gas bearings and to exhaust the scavenged gas.

15. A device according to Claim 14, wherein the receptacle defines multiple exhaust grooves providing differential levels of exhaust.

16. A device according to Claim 15, wherein the differential levels include exhaust to atmosphere, exhaust to a relatively low vacuum, and exhaust to a relatively high vacuum.

17. A device according to any preceding claim, further comprising a position/attitude-adjustment mechanism situated and configured to adjust at least one of position and attitude of the optical component relative to the mounting member without contacting the optical component.

18. A device according to Claim 17, wherein the position/attitude-adjustment mechanism comprises a non-contacting position sensor and a non-contacting positional actuator.

19. A device according to Claim 1, wherein:
the optical component includes as mounting flange;
the receptacle comprises at least one gas bearing situated and configured, whenever gas is being supplied to the gas bearing, to support the mounting flange without contacting the mounting flange; and
each gas bearing comprises an air pad through which gas is discharged, from a gas supply, toward a respective region of the mounting flange.

20. A device according to Claim 19, further comprising at least one exhaust groove extending around the air pad, the at least one exhaust groove serving to scavenge and exhaust gas discharged from the air pad.

21. A device according to Claim 20, wherein the exhaust groove is defined in the receptacle.

22. A device according to Claim 20, wherein:
the receptacle is configured to receive and hold a respective portion of the mounting flange; and
the exhaust groove is defined in the mounting flange.

23. A device according to any preceding claim, further comprising optical-component cooling means for cooling the optical component being held by the holding device.

24. A device according to Claim 23, comprising means for scavenging fluid discharged from the fluid-bearing means.

25. A device according to Claim 24, further comprising means for routing the scavenged fluid to the optical-component cooling means.

26. An optical system according to any one of Claims 23 to 25, wherein the optical component defines an internal cooling passage for conducting a cooling fluid used for cooling the optical component.

27. An optical system according to Claim 26, further comprising a conduit situated and configured to deliver cooling fluid to the internal cooling passage.

28. A device according to any one of Claims 23 to 27, wherein:
the optical component includes a cooling passage for conducting a cooling fluid through the optical component for cooling the optical component; and
the receptacle of the holding device is configured to deliver gas to the cooling passage whenever the optical component is being held by the holding device, so as to allow the gas to flow from the receptacle through the cooling passage and thereby cool the optical component.

29. A device according to any one of Claims 23 to 28, wherein:
the receptacle comprises at least one gas bearing situated and configured, whenever gas is being supplied to the gas bearing, to support the optical component without contacting the optical component; and
the receptacle is configured to route gas discharged from the gas bearing to the cooling passage so as to supply gas to the cooling passage.

30. A device according to any one of Claims 23 to 29, wherein:
the optical component includes a mounting flange;
the receptacle is configured to receive and hold a respective portion of the mounting flange; and
the receptacle is configured to supply a cooling fluid to the cooling passage independently of gas supplied to the gas bearing.

31. A device according to any one of Claims 23 to 30, wherein:
the receptacle comprises at least one gas bearing situated and configured, whenever gas is being supplied to the gas bearing, to support the optical component without contacting the optical component; and
the cooling passage is configured to scavenge gas discharged from the gas bearing and to route the scavenged gas through the cooling passage as the optical component is being held by the holding device.

32. An optical system, comprising:
at least one optical component; and
a device according to any preceding claim for holding the optical component.

33. An optical system according to Claim 32, wherein the optical component is an EUV-reflective mirror.

34. An optical system according to Claim 32 or 33, wherein:
the receptacle comprises at least one gas bearing situated and configured, whenever gas is being supplied to the gas bearing, to support the optical component without contacting the optical component;
the optical component includes a mounting flange; and
the gas bearing imposes a film of gas between the mounting flange and the receptacle so as to support the mounting flange without contacting the mounting flange.

35. A lithographic exposure system, comprising:
a chamber in which lithographic exposure is performed on a substrate by an energy beam; and
an optical system according to any one of Claims 32 to 34 situated within the chamber and configured to direct the energy beam for making the lithographic exposure.

36. A lithographic exposure system according to Claim 35, wherein the optical system is a projection-optical system situated and configured to direct the energy beam to the substrate.

37. A lithographic exposure system according to Claim 35 or 36, wherein:
the chamber is a vacuum chamber; and
the mounting flange or receptacle defines at least one exhaust groove situated and configured, whenever gas is being supplied to the gas bearing, to scavenge the gas discharged from the gas bearing and to exhaust the scavenged gas.

38. A lithographic exposure system according to any one of Claims 35 to 37 wherein:
the optical system is an EUVL-exposure optical system;
the optical component is an ETV-reflective mirror of the EUVL-exposure optical system;
the holding device comprises a gas bearing comprising an air pad and at least one respective exhaust groove at least partially surrounding the air pad; and
the optical component defines an internal cooling passage for conducting a cooling fluid used for cooling the optical component.

39. A method for mounting an optical component in an optical system, the optical system comprising a mounting surface and an optical component that includes a mounting portion, the method comprising:
mounting the optical component to a holding device that defines a receptacle configured to receive the mounting portion and to hold the optical component via the mounting portion without contacting the mounting portion; and
affixing the holding device to the mounting surface of the optical system.

40. A method according to Claim 39, further comprising the step of cooling the optical component as the optical component is being held by the holding device.

41. A method according to Claim 39 or 40, wherein:
the mounting portion of the optical component includes a mounting flange; and
the mounting step comprises inserting the mounting flange into the receptacle.

42. A method according to any one of Claims 39 to 41, wherein the mounting step further includes the step of providing a non-contacting gas bearing between the mounting portion and the receptacle.

43. A method according to Claim 42, wherein the step of providing a gas bearing comprises:
discharging air from a gas pad situated in the receptacle, the air being discharged so as to form the gas bearing; and
scavenging the discharged air from the gas bearing and discharging the air.

44. A method according to any one of Claims 39 to 43, further comprising the step of adjusting at least one of position and attitude of the optical component relative to the mounting surface, without contacting the optical component.
